# EUROPEAN PATENT APPLICATION

(11) **EP 4 439 674 A1**
(43) Date of publication of application: **02.10.2024**
(21) Application number: 24315091.9
(22) Date of filing: 14.03.2024
(51) Int. Cl.: H01L 29/10, H01L 29/417, H01L 29/45, H01L 29/66, H01L 29/739

(54) **INTEGRATED ELECTRONIC DEVICE WITH AN IMPROVED CONDUCTIVE CONTACT STRUCTURE AND RELATED MANUFACTURING PROCESS**

(30) Priority: 28.03.2023 IT 202300005907
(71) Applicant: STMicroelectronics International N.V., 1228 Plan-les-Ouates, Geneva (CH)
(72) Inventor: FAGIANI, Davide, 24010 SORISOLE (BG) (IT); MARIANI, Simone Dario, 20854 VEDANO AL LAMBRO (MB) (IT); GREGOIRE, Magali, 38920 CROLLES (FR); CABARET, Theo, 38330 SAINT NAZAIRE LES EYMES (FR)
(74) Representative: Studio Torta S.p.A.

(57) **Abstract**

Integrated electronic device (1) including: a semiconductor body (2) of silicon delimited by a front surface (S₈) and including at least a first semiconductive region (41,42) of a first conductivity type, which extends into the semiconductor body (2) starting from the front surface (S₈), and a second semiconductive region (40,48) of a second conductivity type, which extends below the first semiconductive region (41,42); a dielectric capping region (15); a trench (39) which extends through the dielectric capping region (15) and through a front portion of the semiconductor body (2), in such a way that a part of the first semiconductive region (41,42) laterally faces the trench (39), said trench (39) partly extending inside the second semiconductive region (40,48); a conductive contact structure (50) extending into the trench (39) and including: a coating region (54,56,58) of titanium silicide, which coats the bottom of the trench (39), in contact with the second semiconductive region (41,42), and also laterally coats the part of the first semiconductive region (41,42) laterally facing the trench (39); and an inner conductive region (72).

## Description

### Technical Field

The present invention relates to an integrated electronic device with an improved conductive contact structure and to the related manufacturing process.

### Background

As is known, conductive contact structures are implemented in semiconductor devices, which contact portions of semiconductor material and are characterized in terms, for example, of current conduction capacity, capacity to function as a barrier against any contaminants, etc.

For example, US 9,385,228 B2 describes a conductive contact structure of multilayer type, which extends in a trench that traverses a capping layer and a portion of an underlying semiconductor body; in particular, a lower portion of the trench traverses implanted semiconductive regions, which function as source regions. Furthermore, the trench is delimited downwardly by a semiconductive contact region, having opposite conductivity type with respect to the source regions. The conductive contact structure comprises a barrier layer, which coats the bottom and the lower portions of the sidewalls of the trench and may be formed by titanium or titanium nitride, and a main layer, which may be of tungsten and is surrounded laterally and downwardly by the barrier layer.

This conductive contact structure allows to increase the contact area between the conductive contact structure and the source regions and the semiconductive contact region, limiting the lateral size. However, it is possible that the contact resistance that characterizes this conductive contact structure is not low enough; furthermore, it is possible that, during the manufacturing process, the barrier layer is subject to mechanical tensions such as to cause local breaks, i.e. it exhibits discontinuities, which entail an increase in the contact resistance.

Examples of conductive contact structures for integrated electronic devices are shown, as an example, in US2015228723A1, US2022093727A1 and EP3671860A1.

The aim of the present invention is therefore to provide a conductive contact structure which has a low contact resistance and is little subject to the local break phenomenon.

### Summary

According to the present invention, an integrated electronic device and a manufacturing process of an integrated electronic device are provided, as defined in the attached claims.

### Brief Description of the Figures

For a better understanding of the present invention, embodiments thereof are now described, purely by way of nonlimiting example, with reference to the attached drawings, wherein:
- Figure 1 schematically shows a cross-section (not to scale) of a portion of an integrated electronic device;
- Figure 2 shows a block diagram of an inverter circuit including an integrated electronic device of the type shown in Figure 1; and
- Figures 3-6 schematically show cross-sections (not to scale) of the integrated electronic,device shown in Figure 1, during successive steps of the manufacturing process.

### Description of Embodiments

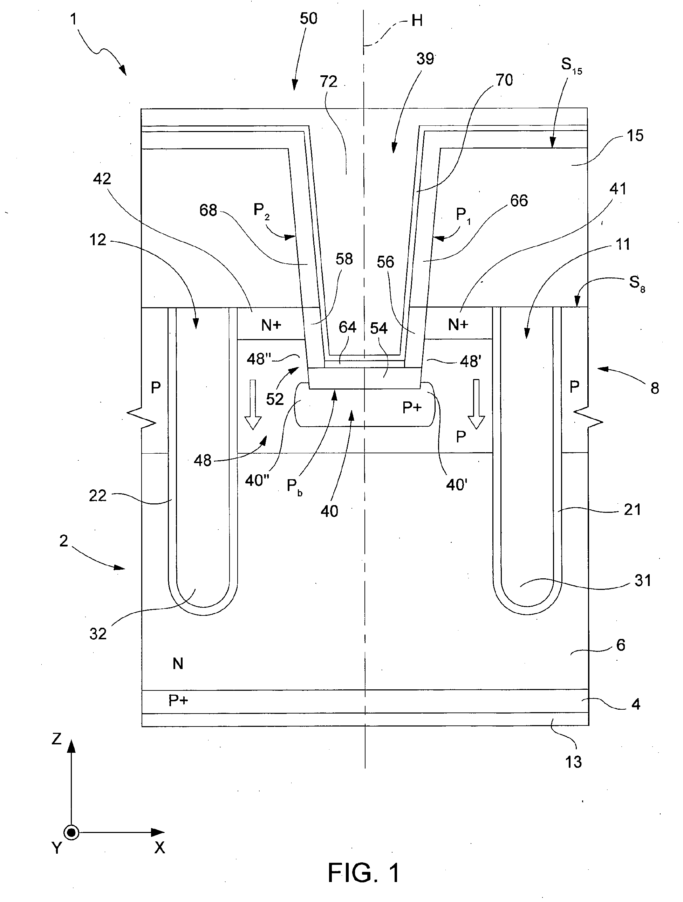

Figure 1 shows an IGBT transistor 1 and an orthogonal reference system XYZ.

The IGBT transistor 1 comprises a semiconductor body 2, which is formed by silicon and includes for example: a substrate 4 of P+-type; a first upper layer 6 of N-type arranged on the substrate 4; and a second upper layer 8 of P-type, which is arranged on the first upper layer 6 and is delimited upwardly by a front surface S₈, which also delimits upwardly the semiconductor body 2 and is parallel to the plane XY.

The IGBT transistor 1 further comprises a plurality of trenches; in Figure 1, for the sake of simplicity, only a first and a second trench 11, 12 are shown, which are for example equal to each other.

The first and the second trenches 11, 12 extend vertically (i.e., along the axis Z) into the semiconductor body 2 starting from the front surface S₈, so as to entirely traverse the second upper layer 8, as well as to extend also in an upper portion of the first upper layer 6. Furthermore, the first and the second trenches 11, 12 are elongated parallel to the axis Y.

The sidewalls and the bottom of the first and, respectively, the second trenches 11, 12 are coated with a first and a second gate insulating region 21, 22, which are formed for example by oxide and contact the semiconductor body 2. Furthermore, a first and a second gate conductive region 31, 32, which are formed for example by polysilicon, extend inside the first and the second trenches 11, 12, respectively.

In particular, the first and the second gate conductive regions 31, 32 are surrounded laterally and downwardly, in direct contact, by the first and, respectively, the second gate insulating regions 21, 22. Furthermore, the first and the second gate conductive regions 31, 32 face the front surface S₈. In practice, the first and the second gate conductive regions 31, 32 form corresponding gate structures with the first and, respectively, the second gate insulating regions 21, 22.

The IGBT transistor 1 also comprises a lower metallization 13, which extends below the substrate 4, in direct contact, and a capping region 15, formed by dielectric material and extending above the front surface 8, in contact with the underlying semiconductor body 2. The capping region 15 is delimited upwardly by a capping surface S₁₅. The lower metallization 13 functions as a collector metallization.

As shown in Figure 1, a further trench 39, hereinafter referred to as the contact trench 39, extends vertically, starting from the capping surface S₁₅, through the capping region 15, as well as through a part of the second upper layer 8, without penetrating the first upper layer 6; furthermore, the contact trench 39 extends parallel to the axis Y.

In greater detail, an upper portion of the contact trench 39 extends through the capping region 15; a lower portion of the contact trench 39 extends into a front portion of the semiconductor body 2. Furthermore, parallel to the axis X, the contact trench 39 is arranged in such a way that the lower portion of the contact trench 39 extends, at a distance, between the first and the second trenches 11, 12.

In even greater detail, the first and the second trenches 11, 12 laterally delimit a corresponding portion 48 of the second upper layer 8, hereinafter referred to as the body region 48.

The semiconductor body 2 also comprises a first and a second source region 41, 42, both of the N+ type, and a body contact region 40 of the P+ type (for example doped with boron and BF₂). In practice, the body contact region 40 is enriched with respect to the body region 48, because it has a doping level higher than the doping level of the body region 48.

The first and the second source regions 41, 42 extend into the second upper layer 8, starting from the front surface S₈, so as to overlie corresponding portions of the underlying body region 48. The body contact region 40 extends inside the body region 48, at the bottom of the contact trench 39, at a greater depth with respect to the maximum depth reached by the first and the second source regions 41, 42, as explained in greater detail below; the body contact region 40 is therefore interposed, at a distance, between the first and the second trenches 11, 12 and is buried in the body region 48.

In practice, the contact trench 39 extends vertically up to a greater depth with respect to the maximum depth having the first and the second source regions 41, 42 extending thereto. Furthermore, the first and the second source regions 41, 42 extend on opposite sides with respect to the contact trench 39. In particular, the first source region 41 extends between the lower portion of the contact trench 39 and the first trench 11, so as to contact the first gate insulating region 21; the second source region 42 extends between the lower portion of the contact trench 39 and the second trench 12, so as to contact the second gate insulating region 21.

In greater detail, the contact trench 39 is delimited downwardly by a bottom wall P_{b}, which is formed by the body contact region 40. Furthermore, without any loss of generality, along the axis X the body contact region 40 has a greater extension with respect to the bottom wall P_{b} of the contact trench 39. A first and a second lateral portion 40', 40" of the body contact region 40 protrude laterally with respect to the bottom wall P_{b} of the contact trench 39 and are separated from the first and, respectively, the second source regions 41, 42 by a first and, respectively, a second portion 48', 48" of the body region 48, which are arranged respectively below the first and the second source regions 41, 42.

In greater detail, the bottom wall P_{b} is approximately parallel to the plane XY and extends to a greater depth with respect to the minimum depth of the first and the second lateral portions 40', 40" of the body contact region 40; in other words, the contact trench 39 partially penetrates the body contact region 40, however the extent of this penetration (for example, comprised between 1nm and 10nm) is negligible as a first approximation.

The contact trench 39 is also laterally delimited by a first and a second sidewall P₁, P₂, each of which comprises a respective portion formed by the capping region 15. Furthermore, a portion of the first sidewall P₁ is formed by the first source region 41; similarly, a portion of the second sidewall P₂ is formed by the second source region 42. Consequently, parts of the first and the second source regions 41, 42 laterally face the contact trench 39.

Furthermore, the first and the second portions 48', 48" of the body region 48 form corresponding portions of the first and, respectively, the second sidewalls P₁, P₂ of the contact trench 39. Finally, lower portions of the first and the second sidewalls P₁, P₂ are formed by the body contact region 40, although as a first approximation these lower portions are negligible. Although not shown, the contact trench 39 may also be delimited by a third and a fourth sidewall (not shown), which are for example approximately parallel to the plane XZ and offset parallel to the axis Y; however, the third and the fourth sidewalls are irrelevant for the purposes of the present description.

The IGBT transistor 1 further comprises a conductive contact structure 50, which extends inside the contact trench 39 and comprises a barrier structure 52, which comprises a bottom barrier region 54 and a first and a second lateral barrier region 56, 58.

The bottom barrier region 54 extends on the bottom of the contact trench 39. In particular, the bottom barrier region 54 coats the bottom wall P_{b}, above the body contact region 40, being in direct contact therewith; furthermore, the bottom barrier region 54 coats the lower portions of the first and the second sidewalls P₁, P₂ and part of the portions of the first and the second sidewalls P₁, P₂ formed by the first and the second portions 48', 48" of the body region 48. The bottom barrier region 54 is formed by titanium silicide, in the TiSi formulation, and has a thickness (measured along the axis Z) for example lower than or equal to 40nm.

The first and the second lateral barrier regions 56, 58 are formed by titanium silicide, in the TiSi and/or TiSi₂ formulation.

The first lateral barrier region 56 coats the portion of the first sidewall P₁ formed by the first source region 41 and part of the portion of the first sidewall P₁ formed by the first portion 48' of the body region 48. Furthermore, downwardly, the first lateral barrier region 56 contacts the bottom barrier region 54.

The second lateral barrier region 58 coats the portion of the second sidewall P₂ formed by the second source region 42 and part of the portion of the second sidewall P₂ formed by the second portion 48" of the body region 48. Furthermore, downwardly, the second lateral barrier region 58 contacts the bottom barrier region 54.

In practice, the first and the second lateral barrier regions 56, 58 are arranged approximately in a manner symmetrical to each other, with respect to a plane H parallel to the plane YZ.

The conductive contact structure 50 further comprises a bottom residual region 64 and a first and a second lateral residual regions 66, 68, which are formed by titanium.

The bottom residual region 64 extends on the bottom of the contact trench 39, above the bottom barrier region 54, being in direct contact therewith. For example, the bottom residual region 64 has a thickness (measured along the axis Z) greater than or equal to 10 nm.

The first lateral residual region 66 coats the portion of the first sidewall P₁ formed by the capping region 15 and contacts, downwardly, the first lateral barrier region 56. The second lateral residual region 68 coats the portion of the second sidewall P₂ formed by the capping region 15 and contacts, downwardly, the second lateral barrier region 58.

The conductive contact structure 50 further comprises an intermediate layer 70 and an inner region 72.

The intermediate layer 70 is formed for example by titanium nitride (TiN), has a thickness for example greater than or equal to 5nm and coats, internally, the first and the second lateral residual regions 66, 68, the first and the second lateral barrier regions 56, 58 and the bottom residual region 64, being in direct contact therewith.

Consequently, each of the first and the second lateral residual regions 66, 68 is interposed between the capping region 15 and the intermediate layer 70. The bottom residual region 64 is interposed between the bottom barrier region 54 and the intermediate layer 70. Furthermore, the first lateral barrier region 56 is interposed between, on one side, the first source region 41 and the first portion 48' of the body region 48, and, on the other side, the intermediate layer 70; the second lateral barrier region 58 is interposed between, on one side, the second source region 42 and the second portion 48" of the body region 48, and, on the other side, the intermediate layer 70.

The inner region 72 is formed for example by tungsten and extends inside the contact trench 39, so as to be coated laterally and downwardly by the intermediate layer 70, being in direct contact therewith. In practice, the inner region 72 fills the contact trench 39. Furthermore, the intermediate layer 70 has the function of preventing the occurrence of chemical reactions between the tungsten of the inner region 72 and the titanium present in the first and the second lateral barrier regions 56, 58, in the bottom residual region 64 and in the first and the second lateral residual regions 66, 68.

Without any loss of generality, in the example shown in Figure 1, portions of the first and the second lateral residual regions 66, 68, hereinafter referred to as the top portions, also extend above the capping surface S₁₅. Furthermore, portions of the intermediate layer 70, hereinafter referred to as the respective top portions, extend above the top portions of the first and the second lateral residual regions 66, 68. In addition, part of the inner region 72 extends above the top portions of the intermediate layer 70.

In practice, the conductive contact structure 50 allows an ohmic contact to be provided with the first and the second source regions 41, 42 and with the body region 48, through the body contact region 40. As regards the first and the second gate conductive regions 31, 32, they may be contacted in a per se known manner and therefore not shown in Figure 1.

In use, by applying suitable voltages to the first and the second gate conductive regions 31, 32, corresponding channel regions are generated, which are formed by corresponding portions of the body regions 48 adjacent, respectively, to the first and the second gate insulating regions 21, 22 and underlying, respectively, the first and the second source regions 41, 42; such channel regions may be traversed by a vertical current, as represented by the arrows shown in Figure 1.

In practice, the first and the second source regions 41, 42 and the gate structures formed in the first and the second trenches 11, 12 form a MOSFET transistor, whose drain is formed by the first upper layer 6. Furthermore, the first and the second source regions 41, 42 form the emitter of a bipolar transistor, whose base is formed by the first upper layer 6 and whose collector is formed by the substrate 4.

This having been said, the Applicant has observed how the ohmic contact obtained through the conductive contact structure 50 is characterized by a low contact resistance, thanks to the presence of the barrier structure 52, which allows a silicide-semiconductor interface to be provided, which is characterized by a low resistance. In particular, the bottom barrier region 54 allows to reduce the contact resistance towards the body contact region 40, which in turn allows to reduce the contact resistance towards the body region 48. Furthermore, thanks to the interposition of the first and the second lateral barrier regions 56, 58, a reduction occurs of the contact resistance towards the first and the second source regions 41, 42, i.e. of the resistance present between the inner region 72 and the portions of the first and the second source regions 41, 42 adjacent to the contact trench 39.

Furthermore, the Applicant has observed how the conductive contact structure 50 is characterized by that the barrier structure 52 has a rather homogeneous shape. In other words, the bottom barrier region 54 and the first and the second lateral barrier regions 56, 58 have substantially uniform thicknesses, therefore they are little subject to local break phenomena, which cause a deterioration of the contact resistance.

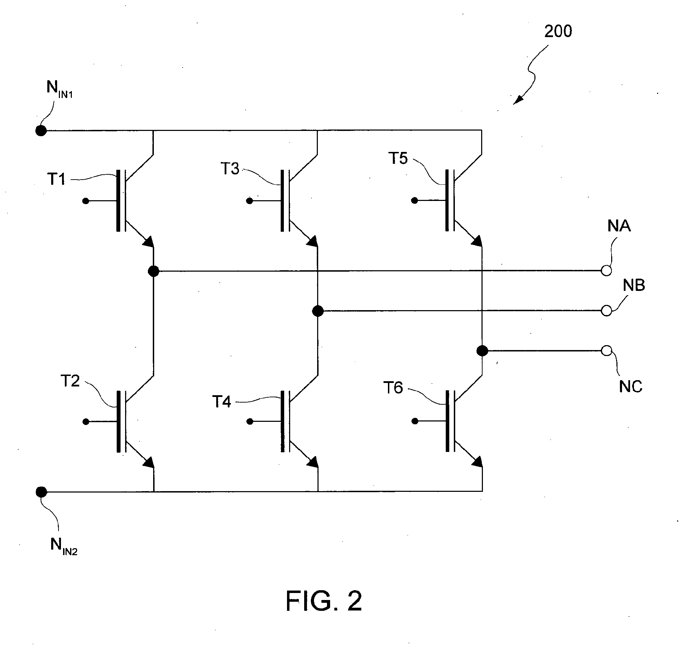

The IGBT transistor 1 may be used to form for example an inverter circuit 200, as shown in Figure 2. In particular, the inverter circuit 200 may include for example a first, a second, a third, a fourth, a fifth and a sixth transistor T1-T6, which are equal to the IGBT transistor 1. The emitters of the first, the third and the fifth transistors T1, T3, T5 are respectively connected to the collectors of the second, the fourth and the sixth transistors T2, T4, T6, so as to form a first, a second and a third output terminal NA, NB, NC, which may be coupled, for example, to an outer electric motor (not shown). The collectors of the first, the third and the fifth transistors T1, T3, T5 are connected to a first supply node N_{IN1}; the emitters of the second, the fourth and the sixth transistors T2, T4, T6 are connected to a second supply node N_{IN2}. The gates of the first, the second, the third, the fourth, the fifth and sixth transistors T1-T6 may be connected to corresponding drive circuits (not shown), which may be external to the inverter circuit 200.

The previously described IGBT transistor 1 may be manufactured by the manufacturing process described hereinbelow.

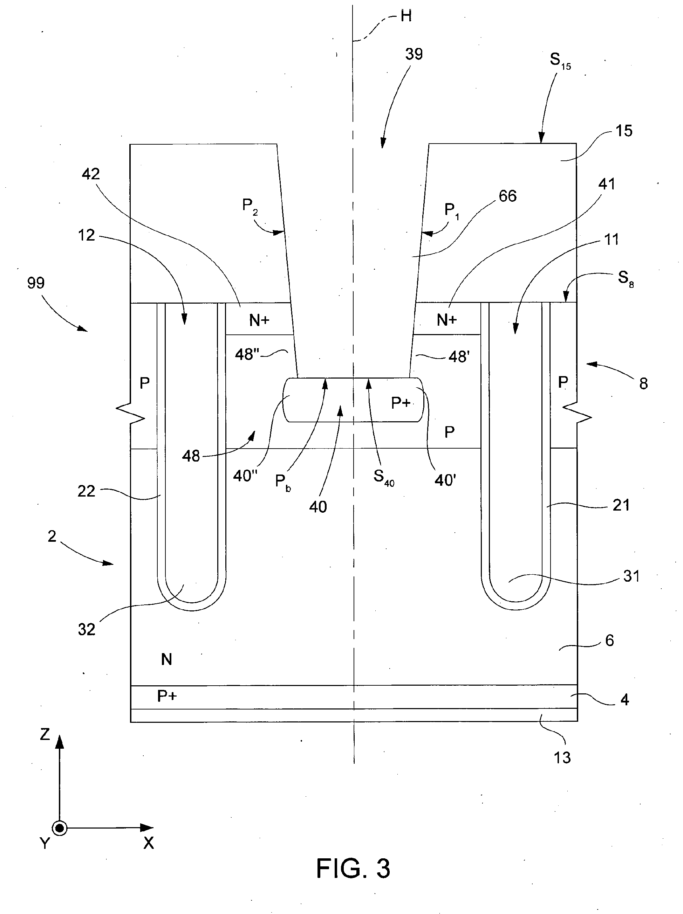

In detail, as shown in Figure 3, in a per se known manner, there are formed, in a semiconductive wafer 99, the semiconductor body 2, the gate structures inside the first and the second trenches 11, 12, the capping region 15 and the contact trench 39, whose bottom wall P_{b} is approximately level with an upper surface (indicated by S₄₀) of the body contact region 40, which is approximately parallel to the plane XY and extends approximately to the same minimum depth of the first and the second lateral portions 40', 40" of the body contact region 40. For example, the first and the second source regions 41, 42 and the body contact region 40 may be manufactured by implant of doping species.

Subsequently, in a manner known per se and not shown here, a cleaning process of the semiconductive wafer 99 based on hydrofluoric acid (HF) may be performed, so as to remove any oxides formed on the semiconductive regions that face the contact trench 39. Furthermore, again in a manner known per se and therefore not shown, a degassing operation may be performed, so as to eliminate any humidity present in the semiconductive wafer 99. Again in a manner known per se and therefore not shown, a further cleaning operation (optional) of the semiconductive wafer 99 may also be performed.

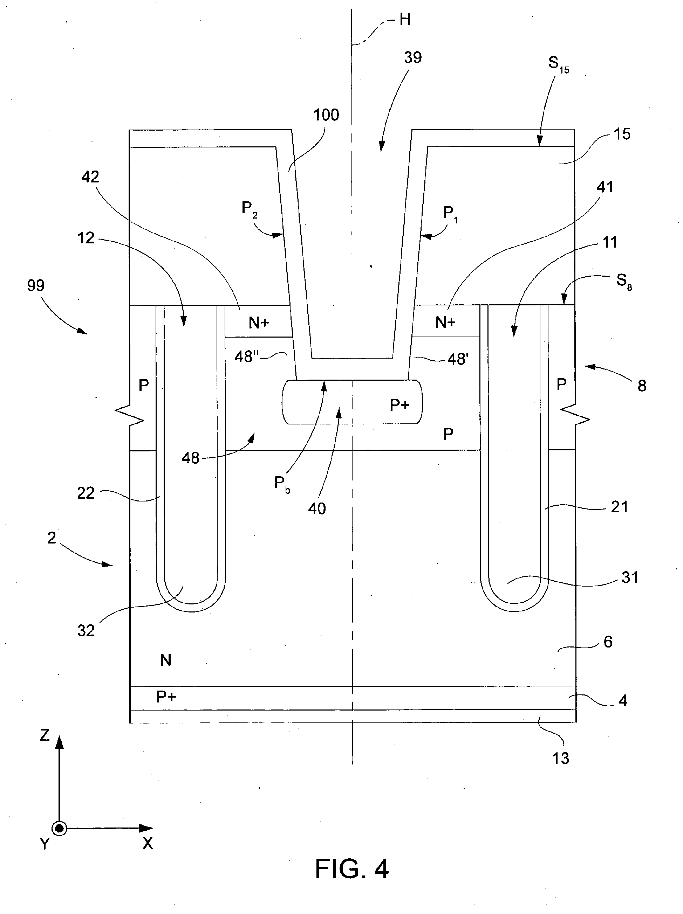

Successively, as shown in Figure 4, a coating layer 100 of titanium is formed, for example by physical vapor deposition (PVD), which coats the first and the second sidewalls P₁, P₂ and the bottom wall P_{b}. The coating layer 100 has a thickness (intended as the thickness, measured along the axis Z, of the portion of the coating layer 100 which overlies the bottom wall P_{b}) for example comprised between 40nm and 60nm. The thickness of the coating layer 100 along the first and the second sidewalls P₁, P₂ may differ with respect to the thickness of the coating layer 100 above the bottom wall P_{b}. Furthermore, without any loss of generality, the coating layer 100 also extends above the capping surface S₁₅.

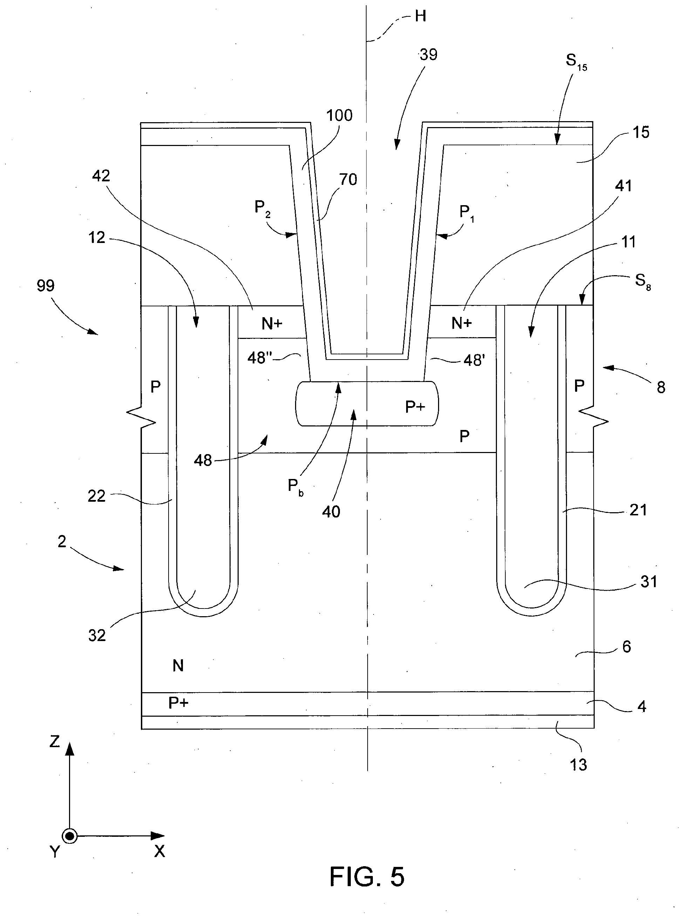

Subsequently, as shown in Figure 5, the intermediate layer 70 of titanium nitride (TiN), which, as previously explained, has a thickness greater than or equal to 5 nm, is formed (for example, by physical or chemical vapor deposition) above the coating layer 100.

Subsequently, an annealing of the semiconductive wafer 99 is performed. In particular, the annealing occurs with a temperature comprised between 450°C and 600°C and has a duration comprised between 40s and 120s.

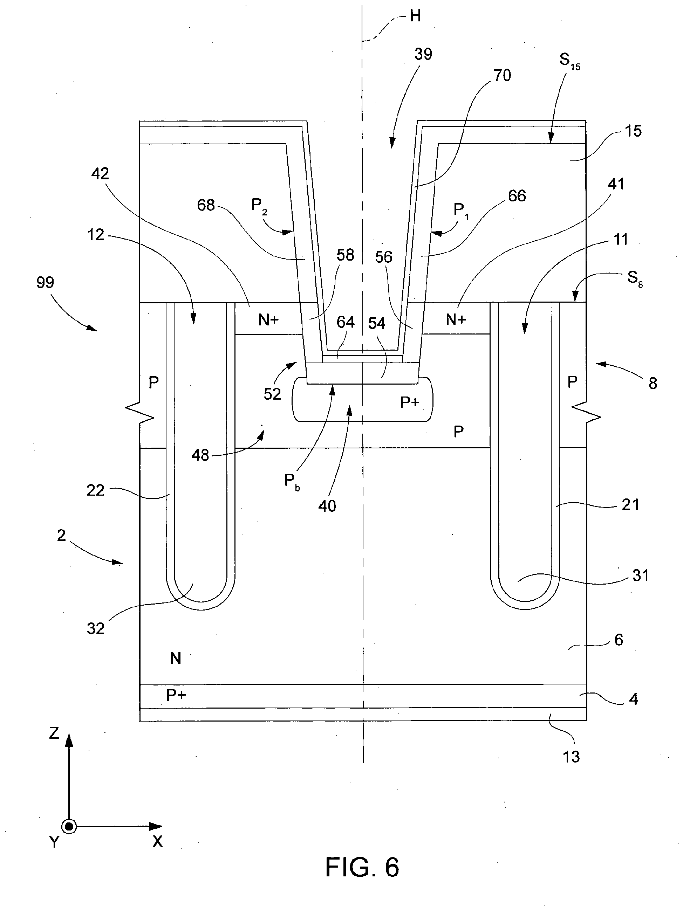

As shown in Figure 6, the annealing causes a transformation of the portion of coating layer 100 that contacts the first source region 41 and the first portion 48' of the body region 48 into the first lateral barrier region 56. Similarly, the annealing causes a transformation of the portion of coating layer 100 that contacts the second source region 42 and the second portion 48" of the body region 48 into the second lateral barrier region 58. In other words,at these portions of the coating layer 100, the titanium is entirely replaced by titanium silicide, in the TiSi and/or TiSi₂ formulation.

Furthermore, the annealing causes a transformation of a part of the portion of the coating layer 100 that overlies the bottom wall P_{b} of the contact trench 39 into the bottom barrier region 54; in fact, a reaction occurs with the silicon of the underlying body contact region 40, resulting in the formation of titanium silicide in the TiSi formulation. A part of the portion of the coating layer 100 overlying the bottom wall P_{b} does not react with the underlying silicon, thus forming the bottom residual region 64. Furthermore, the portions of the coating layer 100 in contact with the capping region 15 do not react and thus form the first and the second lateral residual regions 66, 68, which are formed by titanium.

In greater detail, although not shown, the first and the second lateral residual regions 66, 68 may have different thicknesses with respect to the first and the second lateral barrier regions 56, 58. Furthermore, although not shown, the annealing entails a slight translation (for example comprised between 1nm and 5nm) downward of the bottom wall P_{b}. In fact, a lower portion of the bottom barrier region 54 extends inside the body contact region 40, since silicon atoms of the latter bind with titanium atoms to form the bottom barrier region 54.

Subsequently, although not shown, the manufacturing process provides for forming the inner region 72, such as by chemical vapor deposition of tungsten.

The manufacturing process described allows the conductive contact structure 50 to be formed so as to preserve the body contact region 40, which as a first approximation is not modified by the annealing described. In this manner, a low contact resistance towards the body region 48 is maintained.

Furthermore, the presence of the bottom residual region 64 guarantees that only a part of the portion of the coating layer 100 that overlies the bottom wall P_{b} of the contact trench 39 transforms. In this way, the mechanical stress acting on the bottom barrier region 54 is reduced, thereby reducing the probability of formation of cracks between the bottom barrier region 54 and the first and the second lateral barrier regions 56, 58; furthermore, the risk of partial depletion of the body contact region 40 is reduced.

Finally, it is clear that modifications and variations may be made to the IGBT transistor and to the manufacturing process previously described and illustrated, without departing from the scope of the present invention, as defined in the attached claims.

For example, as previously mentioned, the IGBT transistor 1 may comprise further pairs of first and second trenches 11, 12, each pair being associated with a corresponding conductive contact structure 50 and with a corresponding pair of source regions. In other words, what has been shown in Figure 1 may represent a unit cell of the IGBT transistor 1, which comprises a plurality of unit cells. Furthermore, in a manner known per se, the IGBT transistor 1 may also comprise dummy structures (not shown), each of which is equal to the aforementioned gate structures, but is electrically insulated from the outside world.

Furthermore, the conductive contact structure 50 may also be employed in an integrated electronic device other than an IGBT transistor. In particular, the conductive contact structure 50 may be employed whenever it is necessary to reduce the contact resistance by forming a coating of titanium silicide along lower portions of the walls of a trench which accommodates the conductive contact structure, this coating having an approximately uniform thickness. Furthermore, the Applicant has observed how, thanks to the relatively small thickness of the coating layer 100 and the low temperature of the annealing, no discontinuities occur inside the first and the second lateral barrier regions 56, 58.

The conductivity types (N or P) may also be inverted with respect to what has been described.

The inner region 72 may be formed by a material other than tungsten, such as for example a titanium and tungsten alloy.

The body contact region 40 may also extend upwardly up to contacting the first and the second source regions 41, 42.

Finally, as regards the geometry of the contact trench 39, it may be different. For example, it may have an approximately cylindrical shape, in which case it is laterally delimited by a single sidewall. Furthermore, in this case, the first and the second source regions 41, 42 are not disjoint, but form a single source region, which in top view has approximately an annular shape.

## Claims

1. An integrated electronic device (1) comprising:
- a semiconductor body (2) of silicon delimited by a front surface (S₈) and including at least a first semiconductive region (41,42) of a first conductivity type, which extends into the semiconductor body (2) starting from the front surface (S₈), and a second semiconductive region (40,48) of a second conductivity type, which extends below the first semiconductive region (41,42);
- a dielectric capping region (15), arranged above the semiconductor body (2);
- a trench (39) which extends through the dielectric capping region (15) and through a front portion of the semiconductor body (2), in a manner such that a part of the first semiconductive region (41,42) laterally faces the trench (39), said trench (39) partly extending inside the second semiconductive region (40,48);
said integrated electronic device (1) further comprising a conductive contact structure (50), which extends into the trench (39) and includes:
- a coating region (54,56,58) of titanium silicide, which coats the bottom of the trench (39), in contact with the second semiconductive region (41,42), and also laterally coats said part of the first semiconductive region (41,42) laterally facing the trench (39), in direct contact; and
- an inner conductive region (72), which extends inside the trench (39), a portion of the inner conductive region (72) being surrounded laterally and downwardly by the coating region (54,56,58).

2. The electronic device (1) according to claim 1, wherein the second semiconductive region (40,48) comprises:
- a low-doping region (48), arranged below the first semiconductive region (41,42);
- a high-doping region (40), which extends in the lowdoping region (40);
and wherein the trench (39) is delimited downwardly by the high-doping region (40); and wherein the coating region (54,56,58) contacts the high-doping region (40).

3. The electronic device according to claim 2, wherein the conductive contact structure (50) further comprises an intermediate layer (70) of titanium nitride, which coats the inner conductive region (72) laterally and downwardly and is interposed between the inner conductive region (72) and the coating region (54,56,58).

4. The electronic device according to claim 3, wherein the conductive contact structure (50) further comprises a residual region (64) of titanium, which overlies, in direct contact, a portion (54) of the coating region (54, 56,58) that coats the bottom of the trench (39), said residual region (64) being overlaid, in direct contact, by a portion of the intermediate layer (70).

5. The electronic device according to any of claims 2 to 4, wherein the first semiconductive region (41,42) comprises afirst and a second source region (41,42) laterally offset, arranged on opposite sides of the trench (39); and wherein the trench (39) is laterally delimited by a first and a second sidewall (P₁, P₂), which are formed partly by the first and, respectively, the second source regions (41,42); and wherein the coating region (54,56,58) comprises:
- a bottom barrier region (54), which coats the bottom of the trench (39); and
- a first and a second lateral barrier region (56,58), which contact, downwardly, the bottom barrier region (54) and respectively coat the part of the first sidewall (P₁) formed by the first source region (41) and the part of the second sidewall (P₂) formed by the second source region (42).

6. The electronic device according to claim 5, further comprising:
- at least a first and a second gate trench (11,12), which extend into the semiconductor body (2) starting from the front surface (S₈), so as to laterally delimit the low-doping region (48), which forms a body region (48);
- a first and a second gate conductive region (31,32) extending, respectively, into the first and the second gate trenches- (11,12);
- a first gate dielectric region (21), which extends into the first gate trench (11) so as to coat the first gate conductive region (31) and contacts the first source region (41) and the low-doping region (48);
- a second gate dielectric region (22), which extends into the second gate trench (12) so as to coat the second gate conductive region (32) and contacts the second source region (42) and the low-doping region (48).

7. The electronic device according to any of the preceding claims, said electronic device (1) being an IGBT transistor.

8. An inverter circuit comprising a plurality of electronic devices (T1-T6) according to claim 7.

9. A process for manufacturing an integrated electronic device (1) comprising:
- in a semiconductor body (2) of silicon overlaid by a dielectric capping region (15), delimited by a front surface (S₈) and including at least a first semiconductive region (41,42) of a first conductivity type, which extends into the semiconductor body (2) starting from the front surface (S₈), and a second semiconductive region (40,48) of a second conductivity type, which extends below the first semiconductive region (41,42), forming a trench (39) that extends through the dielectric capping region (15) and through a front portion of the semiconductor body (2), in a manner such that a part of the first semiconductive region (41,42) laterally faces the trench (39), said trench (39) further extending partly inside the second semiconductive region (40,48);
- inside the trench (39), forming a conductive contact structure (50);
and wherein forming a conductive contact structure (50) comprises:
- forming a coating region (54,56,58) of titanium silicide, which coats the bottom of the trench (39)-, in contact with the second semiconductive region (41,42), and also laterally coats said part of the first semiconductive region (41,42) laterally facing the trench (39), in direct contact; and
- forming an inner conductive region (72), which extends inside the trench (39), a portion of the inner conductive region (72) being surrounded laterally and downwardly by the coating region (54,56,58).

10. The manufacturing process according to claim 9, wherein the second semiconductive region (40,48) comprises a low-doping region (48), arranged below the first semiconductive region (41,42), and a high-doping region (40), which extends into the low-doping region (40); and wherein the trench (39) is delimited downwardly by the high-doping region (40); and wherein the coating region (54,56,58) contacts the high-doping region (40).

11. The manufacturing process according to claim 10, wherein forming a conductive contact structure (50) further comprises forming an intermediate layer (70) of titanium nitride, which coats the inner conductive region (72) laterally and downwardly and is interposed between the inner conductive region (72) and the coating region (54,56,58).

12. The manufacturing process according to any of claims 9 to 11, wherein the trench (39) is laterally delimited by sidewalls (P₁,P₂); and wherein forming a coating region (54,56,58) comprises:
- forming a coating layer (100) of titanium on the sidewalls .(P₁, P₂) and on the bottom of the trench (39), so that the coating layer (100) coats said part of the first semiconductive region (41,42) laterally facing the trench (39); and successively
- performing an annealing, so as to transform a portion of the coating layer (100) into said coating region (54,56,58).

13. The manufacturing process according to claim 12 when dependent on claim 11, further comprising, before performing the annealing, forming the intermediate layer. (70) on the coating layer (110).

14. The manufacturing process according to claim 12 or 13, wherein the coating layer (100) has a thickness comprised between 40nm and 60nm; and wherein the annealing occurs with a temperature comprised between 450°C and 600°C and has a duration comprised between 40s and 120s.

15. The manufacturing process according to any of claims 12 to 14, wherein the first semiconductive region (41,42) comprises a first and a second source region (41,42) laterally offset, arranged on opposite sides of the trench (39); and wherein the trench (39) is laterally delimited by a first and a second sidewall (P₁, P₂), which are formed in part by the first and, respectively, the second source regions (41,42); and wherein forming a coating region (54,56,58) comprises:
- coating the bottom of the trench (39) with a bottom barrier region (54); and
- forming a first and a second lateral barrier region (56,58), which contact, downwardly, the bottom barrier region (54) and respectively coat the part of the first sidewall (P₁) formed by the first source region (41) and the part of the second sidewall (P₂) formed by the second source region (42).
